# EUROPÄISCHE PATENTSCHRIFT

(11) **EP 0 277 341 B1**
(45) Veröffentlichungstag und Bekanntmachung des Hinweises auf die Patenterteilung: **10.05.1995**
(21) Anmeldenummer: 87118982.5
(22) Anmeldetag: 21.12.1987
(51) Int. Cl.: H01J 37/32, C23C 14/30

(54) **Anordnung zur Anwendung eines Lichtbogens**
Device for the application of an arc
Dispositif d'application d'un arc

(30) Priorität: 03.02.1987 CH 403/87
(43) Veröffentlichungstag der Anmeldung: 10.08.1988
(73) Patentinhaber: BALZERS AKTIENGESELLSCHAFT, 9496 Balzers (LI)
(72) Erfinder: Buhl, Rainer, Dr., CH-7320 Sargans (CH); Hasler, Christoph, CH-9478 Azmoos (CH)
(74) Vertreter: Troesch, Jacques J., Dr. sc. nat.

(56) Entgegenhaltungen:
- DE-A- 3 345 442
- FR-A- 2 573 441
- US-A- 3 625 848
- US-A- 3 793 179
- US-A- 4 392 932
- US-A- 4 430 184
- US-A- 4 632 719
- PATENT ABSTRACTS OF JAPAN, Band 10, Nr. 104 (E-397)[2161], 19. April 1986;& JP-A-60 242 622
- PATENT ABSTRACTS OF JAPAN, Band 10, Nr. 49 (C-330)[2106], 26. Februar 1986 & JP-A-60 194 068
- B. CHAPMAN "Glow Discharge Processes-Sputtering and Plasma Etching", 1980, John Wiley & Sons, Inc., New York, Seiten 268 bis 270 und 285

## Beschreibung

Die vorliegende Erfindung betrifft eine Anordnung der im Oberbegriff von Anspruch 1 angegebenen Art.

Es ist bekannt, dass bei der genannten Anwendung allein der Lichtbogen das ausgenützte Mittel zum Abtrag der Kathode ist, während bei der Kathodenzerstäubung, wie sie z.B. aus B. Chapman, "Glow Discharge Processes - Sputtering and Plasma Etching", 1980, John Wiley & Sons, Inc. New York, Seiten 268 - 270, 285, der FR-A- 2 573 441, der US-A 4 392 932 oder der US-A- 4 632 719, teilweise auch als Magnetron-Zerstäubungstechnik ausgebildet, bekannt ist, der Abtrag ohne Anwendung eines Lichtbogens zwischen Anode und Kathode erfolgt, lediglich oft entstehende Störlichtbogen (arcing) zu verhindern sind. Bezüglich der bekannten unterschiedlichen Plasma-Entladungen kann auf die US-A 3 625 848 verwiesen werden.

Seit der Anwendung von elektrischen Bogenentladungen zwischen einer Anode und einer Kathode als Verdampferquelle oder als Mittel zur Erzeugung von Festkörperionen besteht der Wunsch, Dampf und Ionenemission auf einen bestimmten Bereich der Kathode zu beschränken, auf den Bereich nämlich, von welchem die ausgesandten Dampfmoleküle bzw. Ionen optimal genutzt werden können, sei es, dass das Material, das verdampft oder ionisiert wird, nur in diesem bestimmten Bereich in der für einen vorgesehenen Verwendungszweck passenden Zusammensetzung vorliegt - man denke z.B. an das Aufdampfen von Legierungen - sei es, dass aus geometrischen Gründen die Emission der Partikel nur von einem bestimmten Bereich der Kathode stattfinden soll, um beispielsweise die Beschichtung von Substraten nur unter bestimmten Einfallsrichtungen durchzuführen oder um die Beschlagung von bestimmten Teilen der Einrichtung in einer Beschichtungsanlage zu verhindern. Schliesslich muss in jedem Falle dafür gesorgt werden, dass der elektrische Lichtbogen nicht so weit an den Rand der Kathode gelangen kann, dass er etwa die Kathodenhalterung oder andere Teile der Einrichtung beschädigt. Dies stellte vor allem dann ein Problem dar, wenn ein gegenüber der Kathode elektrisch positives oder völlig auf Anodenpotential befindliches findliches Bauteil in der Nähe der Kathode angeordnet war, weil in diesem Falle sich der sogenannte Fusspunkt der Bogenentladung, welcher normalerweise in ruckartigen Bewegungen von einer Stelle zu anderen Stellen auf der Kathodenfläche hin- und herwandert, sich in der Nähe eines solchen Bauteiles stabilisieren und dann infolge einer zu langen Brenndauer an der betreffenden Stelle diese zu stark erhitzen konnte, so dass das Bauteil oder die Kathodenhalterung beschädigt wurden. Um dies zu verhindern, waren schon verschiedene Massnahmen vorgeschlagen worden, um die Bewegung des Fusspunktes einer Bogenentladung auf einen vorgewählten Bereich der Kathodenfläche zu beschränken. Diese bisherigen Massnahmen erbrachten aber nur einen gewissen Erfolg in jenen Fällen, wo bei nicht zu hoher Stromstärke die Entladung nur einen Fusspunkt bildete. Wenn aber bei stärkeren Entladungen - von etwa 50 Ampere Gesamtstromstärke aufwärts - sich mehrere Fusspunkte auszubilden begannen (was nach bisheriger Erfahrung nicht zu vermeiden ist), war das Problem mit den bekannten Mitteln kaum mehr zu beherrschen.

In GB-PS 1 322 670 und der entsprechenden US-PS 3 793 179 wird vorgeschlagen, Mittel vorzusehen, um den Fusspunkt einer Bogenentladung zum Erlöschen zu bringen, sobald dieser sich aus dem zulässigen Bereich der Kathodenfläche hinausbewegt. Zu diesem Zweck wurden möglichst nahe, z.B. im Abstand von wenigen Millimetern vor den vor der Entladung zu schützenden Flächenteilen Abschirmbleche angeordnet, die den äusseren Umfang der Kathode ringförmig umgaben. Diese Ringe konnten anscheinend aus beliebigem Material bestehen, nämlich aus elektrisch leitendem Material oder auch aus einem Isolator; empfohlen wurde allerdings, zu dem angegebenen Zweck nur Abschirmungen aus magnetisierbarem Material und zwar aus einem weichmagnetischen Werkstoff, z.B. einem entsprechenden Stahl zu verwenden, weil beobachtet worden sei, dass bei Verwendung einer Abschirmung aus anderem Material die Stabilität der Bogenentladung ungünstig beeinflusst wurde.

In diesem Sinne wurde (noch 10 Jahre nach Bekanntwerden des vorerwähnten Vorschlages) von anderer Seite (DE-OS Nr.33 45 442) nochmals empfohlen, bei einer Vorrichtung zum Stabilisieren eines Verdampfungslichtbogens zur Begrenzung des Kathodenflecks auf der Targetoberfläche einen Begrenzungsring aus magnetisch permeablem (weichmagnetischem) Material vorzusehen, insbesondere einen solchen aus Weicheisen oder aus der Legierung Permalloy. Dies sollte bewirken, dass der Lichtbogen immer wieder auf die Targetoberfläche zurückgelenkt wird, wenn er sich dem Begrenzungsring nähert. Andere Materialien, die für einen solchen Begrenzungsring noch in Frage kämen, seien ausser Eisen auch Nickel und Kobalt oder Legierungen dieser Stoffe. Wichtig sei dabei aber immer, so wurde betont, dass der Begrenzungsring magnetisch permeabel sei, um aufgrund dieser Eigenschaft den Lichtbogen auf der Tagetoberfläche festhalten zu können.

Es schien, dass ein magnetisch permeables Material erfoderlich wäre, um durch den Entladungsstrom ein hinreichend starkes Magnetfeld aufzubauen.

Es wurde nämlich beobachtet, dass ein im Vakuum erzeugter Lichtbogen, der auf ein nicht permeables Target trifft, in zufälliger Weise herumwandert und in etwa einer Sekunde das Target oft verlässt und auf andere Bereiche der Kathode wandert. Bei einem permeablen Target springe der Lichtbogen innerhalb von Millisekunden auf andere Kathodenbereiche über.

Als weitere Möglichkeit zur Stabilisierung eines Verdampferlichtbogens wurde in der DE-PS 33 45 493 und der US-A- 4 430 184 die Lehre gegeben, einen Begrenzungsring zu verwenden, der mit dem Target in Kontakt steht und die Targetoberfläche umgibt, wobei dieser Begrenzungsring aus einem Material bestehen soll, das bei den mittleren Energien der geladenen Teilchen des Lichtbogens ein Sekundärelektronen-Emissionsverhältnis hat, das kleiner als 1 ist, und zur Begrenzung des Kathodenflecks auf die Targetoberfläche eine Oberflächenenergie hat, die kleiner als die des verdampften Targetmaterials ist. Dadurch kehre der Lichtbogen immer wieder auf das Target zurück, wenn er auf die Ringoberfläche gewandert sei.

Speziell wurden für den Begrenzungsring Nitridverbindungen enthaltende Materialien vorgeschlagen und in einer anderen Variante die Verwendung eines Ringes, der aus Eisen oder Permalloy besteht, wobei allenfalls noch eine Schicht mit entsprechendem Sekundärelektronen-Emissionsverhältnis auf dem magnetisch permeablen Ring aufgebracht werden sollte.

Alle diese bekannten Möglichkeiten, die Auswanderung des Lichtbogens von einem erlaubten Bereich der Kathodenfläche zu verhindern, waren für einen Lichtbogen mit nur einem Fusspunkt der Entladung (gerade noch) hinreichend. Bei einer Gesamtstromstärke des Lichtbogens von etwa 50 Ampere aufwärts dagegen bilden sich in zunehmendem Masse mehrere Fusspunkte (Kathodenpunkte", "Kathodeuflecken") aus, und die Erfahrung zeigt, dass in diesem Falle die als optimale Lösung bisher empfohlenen Werkstoffe für die Begrenzungsringe versagten. Es zeigte sich nämlich, dass bei Auftreten mehrerer Entladungsfusspunkte sich der Bogen plötzlich doch an einer Stelle ausserhalb des zugelassenen Kathodenbereiches festsetzen konnte (d.h. dann nicht mehr auf der Kathodenfläche hin- und herwanderte) so dass an dieser Stelle Beschädigungen auftreten konnten, insbesondere konnte ein Durchbrennen der Kathode und der diese tragenden gekühlten Unterlage stattfinden.

Die Ursache dieses statistisch auftretenden Effektes ist nicht ganz klar, aber anscheinend konzentriert sich in diesem Augenblick ein wesentlicher Teil der Gesamtbogen-Stromstärke auf den an einer verbotenen Stelle befindlichen Fusspunkt, wobei dann der Begrenzungsring die ihm zugedachte Funktion nicht mehr erfüllen kann, d.h. nicht mehr in der Lage ist, den randberührenden Lichtbogen von sich wegzudrängen.

Jedenfalls ist immer wieder zu beobachten, dass bei Stromstärken von über 50 Ampere trotz der dann stattfindenden Aufteilung des Gesamtstromes in mehrere getrennte Bögen - sodass man vermuten sollte, dass der einzelne Entladungszweig keine zu grosse Stromstärke führt - trotzdem Beschädigungen auftreten, die bei Entladungen mit nur einem Fusspunkt mit den bisher bekannten magnetisierbaren Begrenzungsringen aus weichmagnetischem Material noch verhindert werden konnten.

Der Zweck der Begrenzungsringe ist, wie gesagt, die scheinbar ziellose Bewegung der Kathodenpunkte, welche die Quelle der Partikelemission bei einer Bogenentladung auf einer kalten Kathode sind, auf die hiefür vorgesehene Fläche der Kathode zu beschränken. Der bisher als beste Lösung bekannte Ring aus magnetisierbarem Material leistet dies für Entladungen mit nur einem Fusspunkt, doch die Sicherheit, mit welcher er diese Funktion erfüllte, ist nicht mehr ausreichend, wenn die Kathode mit einem höheren Bogenstrom betrieben wird, so dass mehrere Fusspunkte zur gleichen Zeit existieren. Im Gegensatz zur bisherigen Auffassung über die Wirkung eines Magnetfeldes nimmt diese Sicherheit sogar noch ab, wenn man, um günstige Bedingungen z.B. für die Aufbringung einer Schicht auf einem Substrat herzustellen, ein zur Kathodenfläche senkrecht stehendes Magnetfeld vorsieht. Schon wenn die Bogenstromstärke nur mässig erhöht wird, so dass sich nur einige wenige Kathodenpunkte gleichzeitig auf der Kathodenfläche bewegen, kommt es nach längerer Einschaltdauer, jedenfalls nach einigen Stunden des Betriebes zum Ausbrechen eines Kathodenpunktes. Er kann sich dann in unerlaubte Bereiche bewegen und beispielsweise in der Nähe von Isolatoren oder sonstigen Bauteilen günstige Brennbedingungen vorfinden und dabei Zerstörungen anrichten. Daher ist auch nur ein gelegentliches Verlassen der vorgesehenen Kathodenfläche im industriellen Betrieb nicht tolerierbar.

Aufgabe der vorliegenden Erfindung ist es nun, ausgehend von einer Anordnung der aus der US-A 3 793 179 bekannten Art, diese so auszubilden, dass sie insbesondere auch bei hohen Stromstärken zuverlässig gegen das Ausbrechen der Fusspunkte des Bogens aus dem für die Verdampfung bzw. Ionenerzeugung vorgesehenen Bereich der Kathodenoberfläche geschützt ist.

Diese Aufgabe wird durch die Ausbildung der genannten Anordnung nach dem Kennzeichen von Anspruch 1 gelöst.

Dabei ist neben einer hinreichenden elektrischen Leitfähigkeit des Begrenzungsringes insbesondere auch wichtig, dass dieser mit dem Target selbst nicht in elektrischem Kontakt steht. Es hat sich gezeigt, dass die erfindungsgemässe Lösung eine wesentlich sicherere Begrenzung der Abbrandfläche der Kathode erbringt als dies mit den bisher als optimal empfohlenen magnetisch permeablen Ringen der Fall ist. Dies trifft vor allem zu für den Fall, dass bei hohen Entladungsstromstärken mehrere Entladungsfusspunkte gebildet werden. Die Erklärung dieser besseren Wirkung ist nicht ganz offensichtlich, aber möglicherweise liegt sie in folgendem:

Bisher wurde davon ausgegangen, dass die Begrenzungsfunktion darauf beruhe, dass durch den dem Begrenzungsring sich näherenden Lichtbogen ein möglichst starkes Magnetfeld erzeugt werden muss, um den Bogen wieder vom Ring nach einer inneren Zone der Kathodenfläche abzudrängen. Um ein hinreichend starkes Magnetfeld durch den Entladungsstrom zu erzeugen, erschien die Verwendung eines Ringes aus magnetisch permeablem Material geboten, da dieses die Magnetfeldstärke erhöht. Nur damit erschien eine hinreichende Begrenzungswirkung also erzielbar zu sein.

Demgegenüber liegt der Erfindung nun die überraschende Erkenntnis zu Grunde, dass eine solche Verstärkungswirkung durch einen magnetisch permeablen Ring gar nicht erforderlich ist, sondern dass - vielleicht wegen der Langsamkeit, mit welcher sich das Magnetfeld bei Verwendung von magnetisch permeablem (meist auch elektrisch leitfähigem) Material ändern kann - vielmehr die Gefahr besteht, dass ein rasch sich zum Ring hin bewegender Lichtbogen diesen erreicht oder gar überspringt, bevor die Verstärkung des Magnetfeldes durch die Permeabilität des Ringmaterials stattfindet. Jedenfalls wurde gefunden, dass bei Verwendung eines Ringes mit einer Oberfläche entsprechend honer elektrischer Leitfähigkeit zumindest bei hohen Bogenströmen über 50 Ampere, bei denen sich bevorzugt mehrere Entladungsfusspunkte ausbilden, die Begrenzungswirkung eines gemäss Erfindung vorgesehenen Begrenzungsringes wesentlich sicherer ist als nach dem bisher bekannten Stand der Technik durch die als optimal geltende Methode erreichbar war.

Die Erklärung für die bessere Wirksamkeit der erfindungsgemässen Anordnung wäre demzufolge vielleicht in der grösseren Schnelligkeit des Magnetfeld-Auf- und Abbaues zu suchen.

Als elektrisch gut leitendes Material für den Begrenzungsring bzw. dessen Oberfläche kommen natürlich in erster Linie die gut leitenden Metalle und aus wirtschaftlichen Gründen vor allem Kupfer und Aluminium in Frage. Der Ringkörper kann knapp über der Kathodenfläche angeordnet sein, wobei der Lichtbogen dann auf den vom Ring umrandeten Teil der Kathodenfläche begrenzt wird, oder er kann die Kathode auch in engem Abstand von ihrem äusseren Rand umgeben, wobei in diesem Falle der Bogen am Verlassen der Kathodenfläche gehindert wird. Unter Ring im Sinne dieser Beschreibung muss nicht unbedingt ein kreisförmiger Ring verstanden werden, vielmehr kann es sich dabei auch um einen ovalen Ring handeln oder sogar um einen rahmenförmig geschlossenen Körper z. B. in Form eines Rechtecks. Ferner kann der Begrenzungsring gemäss Erfindung auch verschiedene Querschnitte aufweisen, z.B. die Form einer flachen Scheibe oder eines Zylindermantels besitzen, wie aus den anhand der anliegenden Zeichnungen beschriebenen Ausführungsbeispielen hervorgeht.

Figur 1 zeigt schematisch eine Vakuumbeschichtungsanlage mit einer Anordnung, bei welcher ein zylindermantelförmiger Begrenzungsring die Kathode umgibt und wobei ausserdem ein Anodenring vorgesehen ist. Die Figur 1 zeigt auch noch eine Hilfseinrichtung zum Zünden der Entladung.

Die Figur 2 zeigt eine Anordnung, bei der das Potential für den Begrenzungsring mittels eines Potentiometers von der Anodenspannung abgegriffen wird.

In Figur 3 ist die am Begrenzungsring liegende Spannung durch den Spannunssabfall an einem in Serie geschalteten Widerstand gegenüber der Anodenspannung herabgesetzt.

In Figur 4 dagegen ist der Ring nicht mehr mit einer Spannungsquelle verbunden, sondern befindet sich in Betrieb auf einem Schwebepotential.

Figur 5 schliesslich zeigt zwei beim Betrieb auf Schwebepotential befindliche Begrenzungsringe, wobei dann die Innenwand der Vakuumkammer als Anode geschaltet werden kann.

Nähere Einzelheiten gehen aus der nachfolgenden Beschreibung der Figuren hervor, wobei analoge Teile in allen Figuren mit den gleichen Hinweisziffern bezeichnet sind.

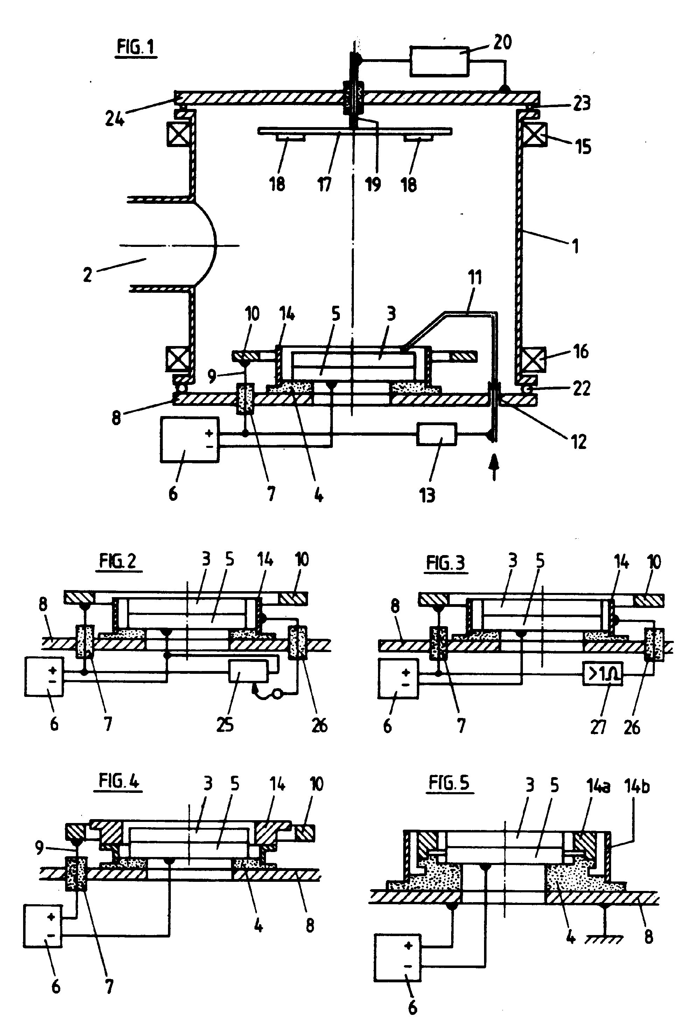

In Figur 1 bedeutet 1 eine zylindrische Vakuumbeschichtungskammer, welche durch die Pumpöffnung 2 evakuiert werden kann. Darin angeordnet ist eine Kathode 3, die am Boden der Anlage befestigt ist, und zwar ruht die Kathode auf einer Unterlage 5, die durch ein in deren Inneren zirkulierendes Kühlmittel die anfallende Verlustwärme abführen kann. Die Kühlunterlage ihrerseits ist von Isolatoren 4 getragen und vakuumdicht mit dem Rezipienten verbunden. Ausserdem ist die Kathode mit dem Negativpol einer Stromquelle 6 verbunden, deren positiver Pol über eine mittels eines Isolators 7 durch die Bodenplatte 8 der Anlage hindurchgeführte Leitung 9 an die ringförmige, als Anode geschaltete Scheibe 10 geführt ist. Vorteilhafterweise ist der Kathode als Hilfseinrichtung ein sogenannter Zündfinger 11 zugeordnet, welcher mittels einer vakuumdicht isolierten durch die Rammerwand hindurchgeführten Betätigungsvorrichtung 12 in Pfeilrichtung bewegt werden kann, so dass man die Kathode mit dem Zündfinger berühren oder diesen von ihr entfernen kann. Der bei Berührung maximal fliessende Strom wird durch einen Widerstand 13 auf einige 10 Ampere begrenzt. Der beim Abheben des Zündfingers von der Kathode entstehende Unterbrechungsfunke entwickelt sich dann zum ersten der Fusspunkte der Bogenentladung.

Im Sinne der Erfindung ist die Kathode 3 von einem zylindermantelförmigen, isolierten und auf dem Isolator 4 aufruhenden Begrenzungsring 14 umgeben, der ein Abwandern der Kathodenpunkte in diesem Falle an die zylindrische Seitenwand der Kathode - verhindert und so die Bewegung derselben auf die Stirnfläche der Kathode beschränkt.

Weiters sind Spulen 15 und 16 vorhanden - sie können als Helmholtzpaar geschaltet sein - welche bewirken, dass schon bei kleiner Feldstärke von 10 Gauss ein Erhöhen der Plasmadichte eintritt. In der Beschichtungskammer ist ferner ein Halter 17 für Substrate 18 drehbar angeordnet und mit einem vakuumdicht und isoliert durch die Kammerwand hindurchgeführten Drehantrieb 19 verbunden, um durch eine Rotationsbewegung der Substrate eine gleichmässigere Beschichtung zu erhalten. Der Substrathalter kann mit der Spannungsquelle 20 auf positives oder negatives Potential gelegt werden. Die Figur 1 deutet ferner Vakuumdichtungen 22 bzw. 23 zwischen dem Boden 8 bzw. dem Deckel 24 und dem zylindrischen Mantel der Vakuumkammer an.

Zur Erprobung der beschriebenen Anlage wurde eine Kathode aus Reintitan eingesetzt und am Substrathalter 17 Substrate 18, die zuvor auf übliche Weise in Lösungsmitteln unter Verwendung von Ultraschall gereinigt worden waren, befestigt. Nach Erreichen von Hochvakuum wurde in die Anlage über den Saugstutzen 2 Argon eingeleitet, bis ein Druck von einigen 10⁻² Pascal erreicht war und sodann die Entladung unter Ausbildung von Kathodenpunkten auf der Kathode gezündet. Gleichzeitig wurde Stickstoff bis zu einem Druck von 10 Pascal eingelassen und dieser Druck während der folgenden Beschichtung konstant gehalten. Der Bogenstrom wurde auf 250 Ampere eingestellt. Nach einer Beschichtungszeit von 8 Minuten erhielt man eine TiN-Schicht von 2 Mikrometern auf den im Abstand von 30 cm montierten Substraten. In einem zweiten Beispiel für eine Probebeschichtung in derselben Anlage wurde in gleicher Weise vorgegangen, nur mit dem Unterschied, dass ein höherer Bogenstrom von 400 Ampere eingestellt wurde. Trotz der Stromstärken von 250 bzw. sogar 400 Ampere brannte der Lichtbogen in beiden Fällen stabil und konnte kein Abwandern von der Kathodenfläche bzw. keine Beschädigung irgendwelcher Teile der Anlage beobachtet werden.

Die Anordnung nach den Figuren 2 bis 5 betreffen, wie oben erwähnt, geometrische Variationen des Begrenzungsringes sowie verschiedene Schaltmöglichkeiten.

In Figur 2 wird die Spannung für den zwischen Anode 10 und Kathode 3 angeordneten Begrenzungsring 14 von einem Potentiometer 25 als Teil der von der Spannungsquelle 6 gelieferten Anodenspannung abgegriffen. Damit lässt sich die Spannung am Begrenzungsring für den Einzelfall optimal einstellen, und es hat sich gezeigt, dass diese etwa halb so gross sein sollte wie die Anodenspannung. Bei den üblichen Anodenspannungen für Niedervoltbogenentladungen von etwa 50 Volt ergibt sich also eine Begrenzungsring-Spannung von etwa 25 Volt. Die Zuführung der Begrenzungsring-Spannung erfolgt über die Spannungsdurchführung 26 durch die Bodenplatte 8 der Anlage.

Die Anordnung der Figur 3 unterscheidet sich von derjenigen nach Figur 2 dadurch, dass die Begrenzungsringspannung zwar auch durch die Anodenspannungsquelle geliefert wird, jedoch wird sie in dieser Schaltung mittels eines elektrischen Widerstandes 27 auf passende Werte reduziert. Dieser Widerstand kann zweckmässigerweise in der Grössenordnung von 1 Ohm liegen; bei einem über den Begrenzungsring fliessenden Strom von z.B. 20 Ampere ergibt sich dann also ein Spannungsabfall von 20 Volt am Widerstand 27, so dass bei einer Bogenspannung von beispielsweise 50 Volt am Begrenzungsring noch eine Restspannung von 30 Volt anliegt.

Die Figur 4 zeigt einen Begrenzungsring 14, der nicht mit einer Spannungsquelle verbunden ist, sondern von dem Isolator 4 getragen sich beim Betrieb infolge Ionenbeschusses aus der Bogenentladung auf ein positives Potential auflädt. Auch ein solcher auf Schwebepotential befindlicher Begrenzungsring erfüllt seine Funktion im Sinne der vorliegenden Erfindung. Es wurde während des Betriebes ein Schwebepotential des Ringes von ungefähr 15 Volt gemessen bei einer Anodenspannung von 40 Volt und einem Bogenstrom von ca. 70 Ampere.

Die Figur 5 zeigt eine Anordnung mit zwei Begrenzungsringen 14a und 14b, die beide ähnlich wie in Figur 4 auf dem Isolator 4 ruhen, wobei bei dieser Anordnung auf eine besondere Anode 10 verzichtet wurde und die Innenwand der Vakuumkammer die Funktion der Anode übernimmt. Die beiden Begrenzungsringe ergeben eine noch höhere Sicherheit gegen unerwünschte Überschläge der Entladung im Bereich des Kathodenrandes und es konnten damit ohne weiteres sogar Bogenstromstärken von mehr als 500 Ampere sicher beherrscht werden. Mit einer so stromstarken Bogenentladung erhält man eine grosse Vielzahl von Fusspunkten der Entladung, so dass in jedem Augenblick ein oder mehrere Fusspunkte sich dem Kathodenrand nähern, aber von dem doppelten Begrenzungsring 14a/14b zuverlässig wieder zurückgedrängt werden. Mit der zuletzt beschriebenen Anordnung nach Figur 5 konnte von einem kathodisch geschalteten Titantarget mit einer Bogenstromstärke von 400 Ampere eine Schicht von 15 mm ohne jede Störung abgetragen werden. Ohne einen erfindungsgemässen Begrenzungsring dagegen traten spätestens nach Abdampfen von Bruchteilen eines Millimeters starke Störungen auf, weil der Kathodenfleck der Entladung an den Kathodenrand läuft und sich dort festsetzt. Mit der Erfindung konnte selbst nach stundenlangem Betrieb dieser Nachteil nicht beobachtet werden.

Auch im Vergleich zu der bekannten Verwendung eines Begrenzungsringes aus magnetisch permeablem Material (Eisenring) erbringt der Kupferring eine vielfach höhere Zuverlässigkeit in der Aufgabe der Begrenzung der Bewegung der Kathodenpunkte auf einen vorgesehen Bereich der Kathodenoberfläche. Im Vergleich zu einem Eisenring nämlich ergab sich beim Versuchsbetrieb mit einer Stromstärke, die mehr als die doppelte Anzahl von Kathodenpunkten auf der Kathode gleicher Grösse erbrachte, kein Ausbrechen der Entladung während der ganzen Lebensdauer einer Kathode, während welcher über 1 cm Materialdicke abgetragen wurde. Es war dabei nur nötig, die auf dem Kupfer niedergeschlagene Schicht des Kathodenmaterials jeweils nach Erreichen einiger Millimeter Dicke wieder zu entfernen.

Dies zeigt, dass die Oberfläche des Begrenzungsringes in Grenzen mit schlechterleitendem Material belegt sein kann, ohne ihre Stabilisierungswirkung zu verlieren.

## Patentansprüche

1. Anordnung mit Kathode (3) und Anode (10; 8) zur Anwendung eines Lichtbogens und zu dessen Stabilisierung zwischen der Anode (10; 8) und der Kathode (3) und mit einem gegenüber der Kathode (3) elektrisch isolierten Begrenzungsring (14) mit elektrisch leitender Oberfläche, der den mit dem Lichtbogen zu beaufschlagenden Teil der Kathodenfläche umgibt und durch die bei Annäherung des Lichtbogens an den Begrenzungsring stattfindende Wechselwirkung zwischen dem Begrenzungsring und dem Lichtbogen eine Aufrechterhaltung des Lichtbogens ausserhalb des zu beaufschlagenden Teils der Kathodenoberfläche verhindert, dadurch gekennzeichnet, dass das Material des Begrenzungsringes an seiner Oberfläche eine elektrische Leitfähigkeit von mindestens 3 x 10⁵ S/cm aufweist, derart, dass der Lichtbogen aufgrund der Wechselwirkung den zu beaufschlagenden Teil der Kathodenfläche nicht verlässt.

2. Anordnung nach Anspruch 1, dadurch gekennzeichnet, dass der Begrenzungsring (14) aus Kupfer besteht.

3. Anordnung nach Anspruch 1, dadurch gekennzeichnet, dass der Begrenzungsring (14) aus Aluminium besteht.

4. Anordnung nach Anspruch 1, dadurch gekennzeichnet, dass der Begrenzungsring als Ringscheibe ausgebildet ist.

5. Anordnung nach Anspruch 1, dadurch gekennzeichnet, dass der Begrenzungsring als Zylindermantel ausgebildet ist.

6. Anordnung nach Anspruch 1, dadurch gekennzeichnet, dass der Begrenzungsring in einem Abstand von höchstens 20 mm über der Kathodenfläche angeordnet ist.

7. Anordnung nach Anspruch 1, dadurch gekennzeichnet, dass der Begrenzungsring mit einer Spannungszuführung (6, 25, 26, 27) versehen ist.

8. Anordnung nach Anspruch 1, dadurch gekennzeichnet, dass der Begrenzungsring gegenüber der Anode und der Kathode der Bogenentladung elektrisch isoliert (14) ist.

9. Anordnung nach Anspruch 1, dadurch gekennzeichnet, dass mehrere Begrenzungsringe (14a, 14b) vorgesehen sind.

## Claims

1. An arrangement having a cathode (3) and an anode (10; 8) for the use of an arc and for the stabilisation thereof between the anode (10; 8) and the cathode (3), and having a restricting ring (14) with an electrically conductive surface, which ring is electrically insulated relative to the cathode (3) and surrounds the part of the cathode surface to be acted upon with the arc and which prevents maintenance of the arc outside the part of the cathode surface to be acted upon thereby, by the interaction which occurs between the restricting ring and the arc when the arc approaches the restricting ring, characterised in that the material of the restricting ring has at its surface an electrical conductivity of at least 3 x 10⁵ S/cm, such that the arc does not leave the part of the cathode surface to be acted upon, because of the interaction.

2. An arrangement according to claim 1 characterised in that the restricting ring (14) comprises copper.

3. An arrangement according to claim 1 characterised in that the restricting ring (14) comprises aluminium.

4. An arrangement according to claim 1 characterised in that the restricting ring is in the form of an annular disc.

5. An arrangement according to claim 1 characterised in that the restricting ring is in the form of a peripheral portion of a cylinder.

6. An arrangement according to claim 1 characterised in that the restricting ring is disposed at a spacing of at most 20 mm above the cathode surface.

7. An arrangement according to claim 1 characterised in that the restricting ring is provided with a voltage feed means (6, 25, 26, 27).

8. An arrangement according to claim 1 characterised in that the restricting ring is electrically insulated (14) relative to the anode and the cathode of the arc discharge.

9. An arrangement according to claim 1 characterised in that there are provided a plurality of restricting rings (14a, 14b).

## Revendications

1. Dispositif comprenant une cathode (3) et une anode (10 ; 8) pour l'utilisation d'un arc électrique et pour la stabilisation de celui-ci entre l'anode (10 ; 8) et la cathode (3), et un anneau de limitation (14) isolé électriquement par rapport à la cathode (3) et à surface électro-conductrice, qui entoure la partie de la surface de cathode à solliciter à l'aide de l'arc électrique et qui empêche un maintien de l'arc électrique à l'extérieur de ladite partie de la surface de cathode à solliciter, grâce à l'interaction entre l'anneau de limitation et l'arc électrique qui a lieu lorsque l'arc électrique s'approche de l'anneau de limitation, caractérisé en ce que le matériau de l'anneau de limitation présente à sa surface une conductibilité électrique d'au moins 3 × 10⁵ S/cm, de sorte que l'arc électrique, en raison de ladite interaction, ne quitte pas la partie de la surface de cathode à solliciter.

2. Dispositif selon la revendication 1, caractérisé en ce que l'anneau de limitation (14) est en cuivre.

3. Dispositif selon la revendication 1, caractérisé en ce que l'anneau de limitation (14) est en aluminium.

4. Dispositif selon la revendication 1, caractérisé en ce que l'anneau de limitation est conçu comme un disque annulaire.

5. Dispositif selon la revendication 1, caractérisé en ce que l'anneau de limitation est conçu comme une enveloppe cylindrique.

6. Dispositif selon la revendication 1, caractérisé en ce que l'anneau de limitation est disposé à une distance maximale de 20 mm au-dessus de la surface de la cathode.

7. Dispositif selon la revendication 1, caractérisé en ce que l'anneau de limitation est pourvu d'une alimentation de tension (6, 25, 26, 27).

8. Dispositif selon la revendication 1, caractérisé en ce que l'anneau de limitation est isolé électriquement (14) par rapport à l'anode et à la cathode de la décharge en arc.

9. Dispositif selon la revendication 1, caractérisé en ce que plusieurs anneaux de limitation (14a, 14b) sont prévus.
